# FASCICULE DE BREVET EUROPEEN

(11) **EP 2 585 334 B1**
(45) Date de publication et mention de la délivrance du brevet: **02.04.2014**
(21) Numéro de dépôt: 11728356.4
(22) Date de dépôt: 06.06.2011
(51) Int. Cl.: B60L 3/00, H02P 9/30, G01R 31/34, H01R 39/58

(54) **PROCEDE DE DETECTION D'USURE BALAIS POUR ALTERNO-DEMARREUR DANS UN VEHICULE**
VERFAHREN ZUM MESSEN VON BÜRSTENVERSCHLEISS IN EINEM WECHSELANLASSER
METHOD OF BRUSH WEAR DETECTION IN A VEHICLE ALTERNATOR / STARTER MOTOR

(30) Priorité: 25.06.2010 FR 1055076
(43) Date de publication de la demande: 01.05.2013
(73) Titulaire: VALEO EQUIPEMENTS ELECTRIQUES MOTEUR, 94046 Créteil Cedex (FR)
(72) Inventeur: GRANZIERA, Cyril, F-75015 Paris (FR); MALBRANQUE, Ronald, F-94300 Vincennes (FR); DUBUS, Jean-Marc, F-77380 Combs La Ville (FR); DEVANNE, Frédéric, F-94100 Saint Maur des Fosses (FR)
(86) Numéro de dépôt international: PCT/FR2011/051272
(87) Numéro de publication internationale: WO 2011/161348

(56) Documents cités:
- EP-A1- 1 551 094
- EP-A1- 1 717 944
- JP-A- 4 347 560

## Description

La présente invention concerne un procédé de détection d'usure balais dans un système à alterno-démarreur couplé à un moteur thermique d'un véhicule.

Des considérations d'économie d'énergie et de réduction de la pollution, surtout en milieu urbain, conduisent les constructeurs de véhicules automobiles à équiper leurs modèles d'une fonctionnalité d'arrêt/relance automatique du moteur thermique, connue sous les termes anglais de « Stop and Go » ou « Stop/Start ».

Un système connu pour implémenter cette fonctionnalité d'arrêt/relance automatique du moteur thermique est un système à alterno-démarreur monté en lieu et place de l'alternateur classique et faisant appel à une machine électrique tournante réversible de type synchrone à rotor bobiné. Dans un tel système à alterno-démarreur, la machine est couplée mécaniquement par courroie au moteur thermique.

Dans un système à alterno-démarreur, la machine électrique tournante peut fonctionner en mode moteur électrique/démarreur lors des phases de démarrage du moteur thermique ou en mode alternateur pour alimenter le réseau électrique du véhicule.

En mode moteur électrique, la machine doit délivrer un couple mécanique conséquent pour entraîner en rotation le moteur thermique et démarrer celui-ci. Le courant d'excitation alimentant la bobine d'excitation du rotor de la machine est sensiblement plus élevé qu'en mode alternateur et il en découle une usure plus rapide des balais.

Lorsque les balais sont en fin de vie, la résistance ohmique de contact entre les balais et les bagues de collecteur du rotor augmente sensiblement. Cette augmentation de la résistance ohmique de contact entraîne un échauffement supplémentaire, notamment en mode démarreur, qui peut se traduire par une détérioration de la machine au niveau du collecteur.

La présente invention concerne un procédé de détection d'usure balais dans un système à alterno-démarreur couplé à un moteur thermique dans un véhicule, le système à alterno-démarreur étant apte à fonctionner dans un mode démarreur et un mode alternateur et comportant une machine électrique tournante, un circuit de puissance, un circuit d'excitation et un circuit de commande, la machine électrique tournante ayant un stator et un rotor, et le circuit d'excitation alimentant en courant d'excitation à travers des balais de la machine une bobine d'excitation logée dans le rotor.

Conformément à l'invention, le procédé comprend les étapes de :
- calculer un rapport cyclique moyen du courant d'excitation lorsque le système à alterno-démarreur fonctionne en mode alternateur;
- comparer le rapport cyclique moyen à une valeur de seuil prédéterminée; et
- détecter une fin de vie des balais lorsque le rapport cyclique moyen devient supérieur à la valeur de seuil prédéterminée.

Selon une autre caractéristique de l'invention, l'étape de calculer un rapport cyclique moyen comporte un filtrage passe-bas d'un rapport cyclique instantané du courant d'excitation. De préférence, le filtrage passe-bas est un filtrage numérique de type récursif.

Selon un mode de réalisation particulier, le filtrage passe-bas a une constante de temps de l'ordre de 30 secondes.

Selon encore une autre caractéristique de l'invention, le procédé comprend également une transmission d'une information de fin de vie de balais à une unité de contrôle électronique du véhicule lorsqu'une fin de vie des balais est détectée.

Selon encore une autre caractéristique de l'invention, le procédé comprend également une transmission d'une information d'anomalie à l'intention du conducteur du véhicule lorsqu'une fin de vie des balais est détectée. Selon un mode de réalisation particulier, cette information d'anomalie est transmise à travers un bus CAN du véhicule et affichée sur un tableau de bord du véhicule.

Selon encore une autre caractéristique de l'invention, le procédé comprend également une désactivation du système à alterno-démarreur lorsqu'une fin de vie des balais est détectée.

Selon un mode de réalisation particulier du procédé de l'invention, celui-ci est mis en oeuvre dans le circuit de commande du système à alterno-démarreur.

Selon un autre mode de réalisation particulier du procédé de l'invention, celui-ci est mis en oeuvre dans une unité de contrôle électronique du véhicule, l'unité de contrôle électronique étant en communication avec le circuit de commande et recevant une information de rapport cyclique du courant d'excitation transmise par le circuit de commande.

L'invention est maintenant décrite au travers de différents modes de réalisation de celle-ci, en référence aux dessins ci-annexés. Il est à noter que ces dessins n'ont d'autre but que d'illustrer le texte de la description et ne constituent en aucune sorte une limitation de la portée de l'invention.

La Fig.1A est une représentation schématique d'un système à alterno-démarreur couplé à un moteur thermique de véhicule dans lequel le procédé de l'invention est mis en oeuvre dans un circuit de commande du système à alterno-démarreur;

la Fig.1B est une représentation schématique d'un système à alterno-démarreur couplé à un moteur thermique de véhicule dans lequel le procédé de l'invention est mis en oeuvre dans une unité de contrôle électronique du véhicule;

la Fig.2 représente sous la forme d'un schéma de principe le traitement de détection de fin de vie des balais effectué dans le procédé selon l'invention; et

la Fig.3 montre des exemples de courbes d'évolution en mode alternateur de rapports cycliques instantané et filtré lorsque les balais de l'alterno-démarreur sont en fin de vie.

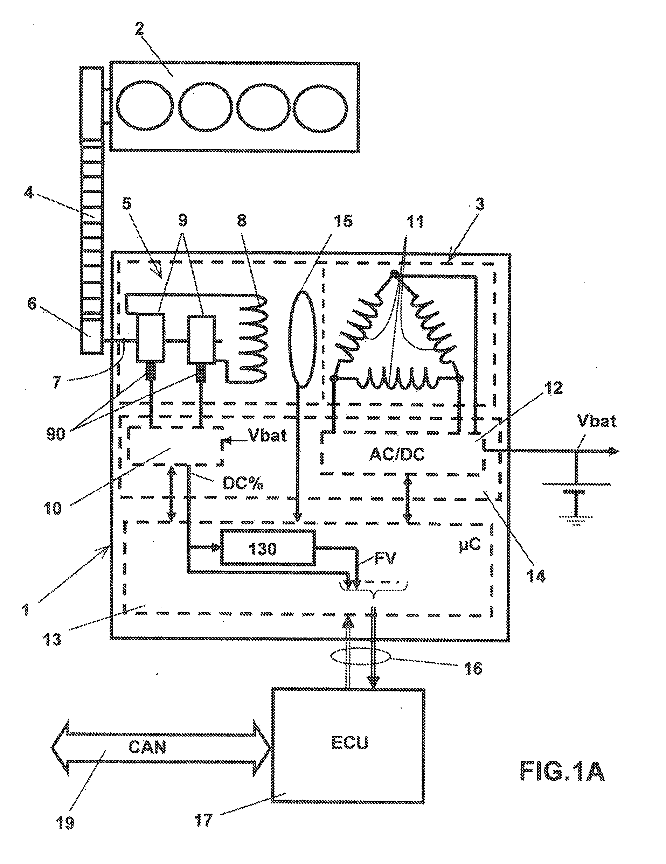

En référence à la Fig.1A, il est maintenant décrit un premier mode de réalisation de l'invention dans un système à alterno-démarreur 1 couplé à un moteur thermique 2 dans un véhicule automobile.

Ce système à alterno-démarreur 1 comprend une machine électrique réversible 3 couplée mécaniquement au moteur 2 au moyen d'une transmission 4 par courroie et poulies.

La machine électrique 3 comporte un rotor 5 solidaire d'une poulie de sortie 6 en bout d'arbre 7. Le rotor 5 présente un inducteur 8 alimenté au moyen d'un collecteur tournant 9 par un circuit d'excitation 10. Des balais 90 sont en appui sur des bagues conductrices du collecteur tournant 9 et autorisent la fourniture par le circuit 10 d'un courant d'excitation à l'intention de l'inducteur 8. Le courant d'excitation alimentant l'inducteur 8 est un courant de type PWM (pour « Pulse Width Modulation » en anglais), c'est-à-dire, un courant à modulation de largeur d'impulsion.

La machine 3 comprend également des enroulements de phases 11, ou induit, alimentés par un convertisseur AC/DC réversible 12.

Un circuit de commande 13 pilote les circuits de puissance 14 de la machine 3, constitués par le convertisseur AC/DC réversible 12 et le circuit d'excitation 10, en fonction des informations fournies par un capteur de la position 15 du rotor 5, et de signaux de contrôle fournis, à travers une liaison 16, par une unité de contrôle électronique (ECU) 17 du véhicule telle qu'une unité de contrôle moteur.

L'unité ECU 17 reçoit des paramètres de fonctionnement du moteur 2, et d'autres informations de contexte par des liaisons filaires dédiées (non représentées) ou par un bus de communication de données 19 embarqué de type CAN.

Le convertisseur AC/DC réversible 12 est typiquement formé d'un pont à transistors de type MOSFET qui, lorsque le système à alterno-démarreur 1 fonctionne en mode moteur, génère des impulsions de courant alimentant les enroulements de phases 11 de la machine, impulsions dont la fréquence et la largeur sont contrôlées par le circuit de commande 13.

Le convertisseur AC/DC réversible 12 fonctionne en redresseur synchrone quand le système à alterno-démarreur 1 fonctionne en mode alternateur.

Conformément à l'invention, le circuit de commande 13 comporte un module logiciel de détection d'usure balais 130 destiné à détecter une fin de vie des balais 90. Le module 130 est activé lorsque le système à alterno-démarreur 1 fonctionne en mode alternateur.

Dans le mode alternateur, le circuit d'excitation 10 régule la tension Vbat de manière à stabiliser celle-ci à une valeur égale à une tension de consigne. La tension de consigne est ici fournie par l'unité ECU 17 au circuit d'excitation 10, par l'intermédiaire de la liaison de communication 16 et du circuit de commande 13. En retour, un rapport cyclique DC% appliqué au courant d'excitation de type PWM est transmis à l'unité de commande électronique 17 pour information de l'état de charge effectif de la machine en mode alternateur. Le rapport cyclique DC% est appelé «rapport cyclique instantané» dans la suite de la descrption.

Le module logiciel de détection d'usure balais 130 détecte la fin de vie des balais 90 à partir d'un traitement effectué en mode alternateur sur le rapport cyclique instantané DC%. Lorsqu'une fin de vie des balais est détectée par le module 130, un signal de fin de vie de balais FV est délivré par le module 130. De préférence, l'information du signal FV est stockée dans une mémoire non-volatile du circuit de commande 13 pour d'éventuelles opérations de service après-vente. Ce signal FV est fourni ensuite à l'unité ECU 17 à travers la liaison de communication 16. Lorsque l'unité ECU 17 est informée de la fin de vie des balais 90, elle désactive le système à alterno-démarreur 1. De plus, l'unité ECU 17 commande une information destinée à l'utilisateur de la nécessité de procéder à une opération de service après-vente, par exemple, en ordonnant à travers le bus CAN 19 l'affichage d'une information d'anomalie sur le tableau de bord du véhicule.

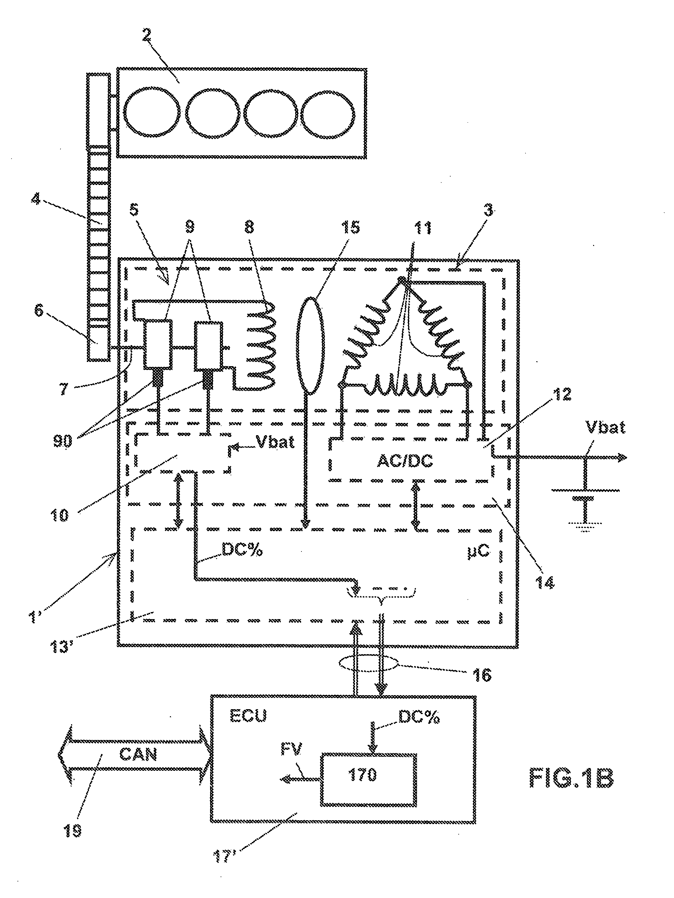

En référence à la Fig.1B, il est maintenant décrit un second mode de réalisation de l'invention dans un système à alterno-démarreur 1'.

A la Fig.1B, les éléments ayant les mêmes repères que ceux indiqués à la Fig.1A restent identiques et ne seront pas décrits de nouveau ci-après.

Dans le mode de réalisation de la Fig.1B, il est prévu un module logiciel de détection d'usure balais comme dans le mode de réalisation de la Fig.1A, mais ce module logiciel, repéré 170 à la Fig.1B, est implanté dans l'unité ECU, repéré 17' à la Fig.1B, et non dans le circuit de commande, repéré 13' à la Fig.1B.

A la Fig.1B, le rapport cyclique instantané DC% est fourni au module logiciel 170 par l'intermédiaire du circuit de commande 13' et de la liaison de communication 16. Le traitement effectué par le module logiciel de détection d'usure balais 170 est similaire à celui effectué par le module 130. Lorsqu'une fin de vie des balais 90 est détectée par le module 170, le signal FV est délivré par le module 170 directement à l'ECU 17' qui opère ensuite comme indiqué ci-dessus pour le premier mode de réalisation de l'invention en référence à la Fig.1A.

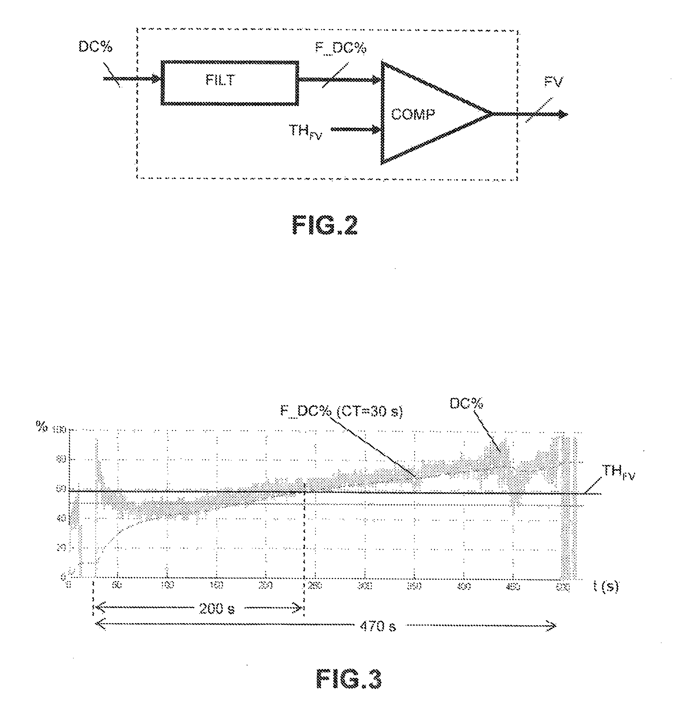

Le traitement réalisé par les modules 130 et 170 est maintenant décrit en référence aux Figs.2 et 3.

Comme montré à la Fig.2, le traitement effectué par les modules 130, 170 comprend une étape de calcul de filtrage FILT et une étape de comparaison COMP.

L'étape de calcul de filtrage FILT fait appel à un filtrage passe-bas du premier ordre et comporte un filtrage numérique récursif du rapport cyclique instantané DC% afin d'obtenir un rapport cyclique moyen F_DC%.

A la Fig.3 sont montrées des courbes représentant des évolutions dans le temps du rapport cyclique DC% et du rapport cyclique moyen F_DC% obtenu par le filtrage récursif FILT.

Un seuil TH_{FV} est également montré à la Fig.3. Dans les modes de réalisation décrits ici, le seuil TH_{FV} est choisi égal à un rapport cyclique de 60%. Bien entendu, d'autres valeurs pourront être choisies, selon les applications de l'invention.

Le signal de fin de vie de balais FV est activé, FV= «1 », lorsque la valeur du rapport cyclique moyen F_DC% dépasse le seuil TH_{FV}=60% dans le mode de fonctionnement alternateur du système à alterno-démarreur 1, 1'.

De manière générale dans un alterno-démarreur, la puissance requise pour le fonctionnement en mode démarreur est sensiblement supérieure à la puissance requise en mode alternateur. Dans un alterno-démarreur à rotor à griffes, du type machine de Lundell, la résistance ohmique du rotor est rendue faible de manière à permettre, en mode démarreur, le passage d'un courant d'excitation important adapté pour l'obtention du couple mécanique nécessaire au démarrage du moteur thermique.

En mode démarreur, le rapport cyclique DC% du courant d'excitation peut évoluer jusqu'à DC% = 100%.

En mode alternateur, l'évolution du rapport cyclique DC% reste normalement inférieure à 60% lorsque les balais de la machine sont en bon état. En cas d'usure des balais, la résistance de contact entre les bagues de collecteur et les balais augmente. Il en découle donc que pour une même charge de la machine et une même tension de sortie régulée, le rapport cyclique DC% augmente.

Les courbes d'évolution des rapports cycliques DC% et F_DC% montrées à Fig.3 sont des exemples de courbes obtenues lorsque les balais de la machine sont en fin de vie. La constante de temps CT du filtrage effectué pour obtenir le rapport F_DC% doit être suffisamment grande pour éviter tout risque de fausse détection. Dans cet exemple, la constante de temps choisie est égale à CT=30 s.

On constate à la Fig.3 que le seuil TH_{FV}=60% est franchi au bout de 200 s environ après un passage en mode alternateur. Comme montré à la Fig.3, si aucune mesure de désactivation de la machine n'est prise, un circuit ouvert s'établit au bout de 470 s environ dans le circuit d'excitation de la machine et il s'ensuit une perte du mode alternateur. Dans une telle situation, sans aucune mesure de désactivation de la machine, le collecteur a le temps de se dégrader. Par la détection de l'usure des balais qu'autorise la présente invention, il est possible de désactiver la machine avant toute dégradation et d'alerter le conducteur sur l'occurrence d'une anomalie dans l'alternateur et/ou de la nécessité de changer les balais.

## Revendications

1. Procédé de détection d'usure balais dans un système à alterno-démarreur (1, 1') couplé à un moteur thermique (2) dans un véhicule, ledit système à alterno-démarreur (1, 1') étant apte à fonctionner dans un mode démarreur et un mode alternateur et comportant une machine électrique tournante (3), un circuit de puissance (12), un circuit d'excitation (10) et un circuit de commande (13, 13'), ladite machine électrique tournante (3) ayant un stator (11) et un rotor (5), et ledit circuit d'excitation (10) alimentant en courant d'excitation à travers des balais (90) de ladite machine (3) une bobine d'excitation logée dans ledit rotor (5), **caractérisé en ce que** ledit procédé comprend les étapes de :
- calculer (FILT) un rapport cyclique moyen (F_DC%) dudit courant d'excitation lorsque ledit système à alterno-démarreur (1, 1') fonctionne en mode alternateur;
- comparer ledit rapport cyclique moyen (F_DC%) à une valeur de seuil prédéterminée (TH_{FV}); et
- détecter une fin de vie (FV) desdits balais (90) lorsque ledit rapport cyclique moyen (F_DC%) devient supérieur à ladite valeur de seuil prédéterminée (TH_{FV}).

2. Procédé selon la revendication 1, **caractérisé en ce que** ladite étape de calculer (FILT) un rapport cyclique moyen (F_DC%) comporte un filtrage passe-bas d'un rapport cyclique instantané (DC%) dudit courant d'excitation.

3. Procédé selon la revendication 2, **caractérisé en ce que** ledit filtrage passe-bas est un filtrage numérique de type récursif.

4. Procédé selon la revendication 2 ou 3, **caractérisé en ce que** ledit filtrage passe-bas a une constante de temps de l'ordre de 30 secondes.

5. Procédé selon l'une quelconque des revendications 1 à 4, **caractérisé en ce qu'**il comprend également une transmission d'une information de fin de vie de balais (FV) à une unité de contrôle électronique (ECU, 17, 17') dudit véhicule lorsqu'une fin de vie des balais est détectée.

6. Procédé selon l'une quelconque des revendications 1 à 5, **caractérisé en ce qu'**il comprend également une transmission d'une information d'anomalie à l'intention du conducteur du véhicule lorsqu'une fin de vie des balais est détectée.

7. Procédé selon la revendication 6, **caractérisé en ce que** ladite information d'anomalie est transmise à travers un bus CAN dudit véhicule et affichée sur un tableau de bord du véhicule.

8. Procédé selon l'une quelconque des revendications 1 à 7, **caractérisé en ce qu'**il comprend également une désactivation dudit système à alterno-démarreur lorsqu'une fin de vie des balais est détectée.

9. Procédé selon l'une quelconque des revendications 1 à 8, **caractérisé en ce qu'**il est mis en oeuvre dans ledit circuit de commande (13) dudit système à alterno-démarreur (1).

10. Procédé selon l'une quelconque des revendications 1 à 8, **caractérisé en ce qu'**il est mis en ceuvre dans une unité de contrôle électronique (ECU, 17') dudit véhicule, ladite unité de contrôle électronique (ECU, 17') étant en communication (16) avec ledit circuit de commande (13') et recevant une information de rapport cyclique (DC%) dudit courant d'excitation transmise par ledit circuit de commande (13').

## Patentansprüche

1. Verfahren zum Detektieren des Bürstenverschleißes in einem Drehstromanlasser-System (1, 1'), das mit einer Brennkraftmaschine (2) in einem Fahrzeug gekoppelt ist, wobei das Drehstromanlasser-System (1, 1') in einem Anlassermodus und in einem Drehstrommodus arbeiten kann und eine rotierende elektrische Maschine (3), eine Leistungsschaltung (12), eine Erregungsschaltung (10) und eine Steuerschaltung (13, 13') umfasst, wobei die rotierende elektrische Maschine (3) einen Stator (11) und einen Rotor (5) besitzt und wobei die Erregungsschaltung (10) eine Erregungsspule, die sich in dem Rotor (5) befindet, über Bürsten (90) der Maschine (3) mit Erregungsstrom versorgt, **dadurch gekennzeichnet, dass** das Verfahren die folgenden Schritte umfasst:
- Berechnen (FILT) eines mittleren Tastverhältnisses (F_DC%) des Erregungsstroms, wenn das Drehstromanlasser-System (1, 1') im Drehstrommodus arbeitet;
- Vergleichen des mittleren Tastverhältnisses (F_DC%) mit einem vorgegebenen Schwellenwert (TH_{FV}); und
- Detektieren eines Lebensdauerendes (FV) der Bürsten (90), wenn das mittlere Tastverhältnis (F_DC%) größer wird als der vorgegebene Schwellenwert (TH_{FV}).

2. Verfahren nach Anspruch 1, **dadurch gekennzeichnet, dass** der Schritt zum Berechnen (FILT) eines mittleren Tastverhältnisses (F_DC%) eine Bandpassfilterung eines momentanen Tastverhältnisses (DC%) des Erregungsstroms umfasst.

3. Verfahren nach Anspruch 2, **dadurch gekennzeichnet, dass** die Bandpassfilterung eine digitale Filterung des rekursiven Typs ist.

4. Verfahren nach Anspruch 2 oder 3, **dadurch gekennzeichnet, dass** die Bandpassfilterung eine Zeitkonstante in der Größenordnung von 30 Sekunden hat.

5. Verfahren nach einem der Ansprüche 1 bis 4, **dadurch gekennzeichnet, dass** es außerdem eine Übertragung von Informationen bezüglich des Lebensdauerendes der Bürsten (FV) an eine elektronische Steuereinheit (ECU, 17, 17') des Fahrzeugs, wenn ein Ende der Lebensdauer der Bürsten detektiert wird, umfasst.

6. Verfahren nach einem der Ansprüche 1 bis 5, **dadurch gekennzeichnet, dass** es außerdem eine Übertragung von Anomalieinformationen zum Fahrer des Fahrzeugs, wenn ein Lebensdauerende der Bürsten detektiert wird, umfasst.

7. Verfahren nach Anspruch 6, **dadurch gekennzeichnet, dass** die Anomalieinformationen über einen CAN-Bus des Fahrzeugs übertragen werden und auf einer Instrimententafel des Fahrzeugs angezeigt werden.

8. Verfahren nach einem der Ansprüche 1 bis 7, **dadurch gekennzeichnet, dass** es außerdem eine Deaktivierung des Drehstromanlasser-Systems, wenn ein Lebensdauerende der Bürsten detektiert wird, umfasst.

9. Verfahren nach einem der Ansprüche 1 bis 8, **dadurch gekennzeichnet, dass** es in der Steuerschaltung (13) des Drehstromanlasser-Systems (1) ausgeführt wird.

10. Verfahren nach einem der Ansprüche 1 bis 8, **dadurch gekennzeichnet, dass** es in einer elektronischen Steuereinheit (ECU, 17') des Fahrzeugs ausgeführt wird, wobei die elektronische Steuereinheit (ECU, 17') mit der Steuerschaltung (13') kommuniziert (16) und Informationen bezüglich des Tastverhältnisses (DC%) des Erregungsstroms, die von der Steuerschaltung (13') übertragen werden, empfängt.

## Claims

1. Method for detecting brush wear in an alternator-starter system (1, 1') coupled to a heat engine (2) in a vehicle, said alternator-starter system (1, 1') being able to operate in a starter mode and an alternator mode and comprising a rotating electrical machine (3), a power circuit (12), an excitation circuit (10) and a control circuit (13, 13'), said rotating electrical machine (3) having a stator (11) an a rotor (5), and said excitation circuit (10) supplying excitation current, through the brushes (90) of said machine (3), to an excitation coil housed in said rotor (5), **characterized in that** said method comprises the steps of:
- calculating (FILT) an average duty cycle (F_DC%) of said excitation current when said alternator-starter system (1, 1') operates in alternator mode;
- comparing said average duty cycle (F_DC%) to a predetermined threshold value (TH_{FV}); and
- detecting an end of life (FV) of said brushes (90) when said average duty cycle (F_DC%) becomes greater than said predetermined threshold value (TH_{FV}).

2. Method according to Claim 1, **characterized in that** said step of calculating (FILT) an average duty cycle (F_DC%) comprises a low-pass filtering of an instantaneous duty cycle (DC%) of said excitation current.

3. Method according to Claim 2, **characterized in that** said low-pass filtering is a digital filtering of recursive type.

4. Method according to Claim 2 or 3, **characterized in that** said low-pass filtering has a time constant of the order of 30 seconds.

5. Method according to any one of Claims 1 to 4, **characterized in that** it also comprises a transmission of an end-of-brush-life indication (FV) to an electronic control unit (ECU, 17, 17') of said vehicle when an end of life of the brushes is detected.

6. Method according to any one of Claims 1 to 5, **characterized in that** it also comprises a transmission of an error indication for the attention of the driver of the vehicle when an end of life of the brushes is detected.

7. Method according to Claim 6, **characterized in that** said error indication is transmitted via a CAN bus of said vehicle displayed on a vehicle dashboard.

8. Method according to any one of Claims 1 to 7, **characterized in that** it also comprises a deactivation of said alternator-starter system when an end of life of the brushes is detected.

9. Method according to any one of Claims 1 to 8, **characterized in that** it is implemented in said control circuit (13) of said alternator-starter system (1).

10. Method according to any one of Claims 1 to 8, **characterized in that** it is implemented in an electronic control unit (ECU, 17') of said vehicle, said electronic control unit (ECU, 17') being in communication (16) with said control circuit (13') and receiving an indication of the duty cycle (DC%) of said excitation current transmitted by said control circuit (13').
